(19) Europäisches Patentamt

European Patent Office

Office européen des brevets

(11) **EP 0 766 388 B1**

(12) **EUROPEAN PATENT SPECIFICATION**

(45) Date of publication and mention
of the grant of the patent:
**07.12.2005 Bulletin 2005/49**

(51) Int Cl.⁷: **H03H 17/02**

(21) Application number: **96306660.0**

(22) Date of filing: **13.09.1996**

(54) **Method for processing signal in CSD filter and circuit suitable for the method**

Signalverarbeitungsverfahren in CSD-Filter und Schaltung dafür

Méthode de traitement de signaux dans un filtre CSD et circuit pour cette méthode

(84) Designated Contracting States:
**DE FR GB**

(30) Priority: **30.09.1995 KR 9533999**

(43) Date of publication of application:
**02.04.1997 Bulletin 1997/14**

(73) Proprietor: **SAMSUNG ELECTRONICS CO., LTD.**
**Suwon-city, Kyungki-do (KR)**

(72) Inventor: **Lee, Myeong-Hwan**
**Paldal-gu, Suwon-city, Kyungki-do (KR)**

(74) Representative: **Chugg, David John**
**Appleyard Lees,**
**15 Clare Road**
**Halifax, West Yorkshire HX1 2HY (GB)**

(56) References cited:
**EP-A- 0 292 189**

• **SAMUELI H: "AN IMPROVED SEARCH ALGORITHM FOR THE DESIGN OF MULTIPLIERLESS FIR FILTERS WITH POWERS-OF-TWO COEFFICIENTS" IEEE TRANSACTIONS ON CIRCUITS AND SYSTEMS, vol. 36, no. 7, July 1989, pages 1044-1047, XP000054038**
• **SHOUSHENG HE ET AL: "FPGA IMPLEMENTATION OF FIR FILTERS USING PIPELINED BIT-SERIAL CANONICAL SIGNED DIGIT MULTIPLIERS" PROCEEDINGS OF THE CUSTOM INTEGRATED CIRCUITS CONFERENCE, SAN DIEGO, MAY 1 - 4, 1994, no. CONF. 16, 1 May 1994, INSTITUTE OF ELECTRICAL AND ELECTRONICS ENGINEERS, pages 81-84, XP000492860**

EP 0 766 388 B1

**Description**

The present invention relates to a method for processing a signal in a filter employing a Canonic Signed Digit (CSD) code and a circuit suitable for the method, and more particularly, to a method for processing a signal in a CSD filter, which can improve the performance of the filter and can be adapted to many kinds of filters by increasing the resolution of scaling factors, and a circuit suitable for the method.

A digital filter is the most important and the most frequently used element for processing a digital signal. The digital filter is comprised of delays, multipliers and adders. The simplest form of digital filter is a multiplier with no delay. This type of filter is mostly used for processing a signal, e.g., controlling gains.

The complexity of the digital filter depends on its length, mainly, and then bit resolution determined by the number of bits of an input signal, the coefficients of a multiplier, i.e. filter coefficients, and the number of bits of an adder.

The digital filter is generally comprised of a plurality of multipliers. The multipliers, which occupy large areas and consume much power, impose constraints on a one-chip solution when circuits are integrated. In fact, in applications of digital signal processing, a digital filter shorter than is needed has recently been used in consideration of the one-chip solution, when multi-functions are implemented using the filters. An interpolation filter relying on bilinear characteristics of a fixed coefficient is an example.

In this aspect, efforts have been expended on reduction of hardware complexity by simplifying multipliers of a digital filter. A multiplier employing a CSD code for a digital filter has been explored as an exemplary effort.

To obtain a filter employing the CSD code, all real coefficients of the designed filter must be converted into CSD coefficients. However, when the conversion is performed simply by quantization, the performance of the filter degrades to a great extent. Thus, many optimization techniques have been suggested in (1) "FIR filter design over a discrete powers-of-two coefficients space" by Y. C. Lim and B. R. Parker, IEEE Trans. on Acoust., Speech and Signal Processing, vol. ASSP-31, pp. 583-591, June 1983; (2) "A simple design of FIR filters with powers-of-two coefficients" by Q. Zhao and Y. Tadokoro, IEEE Trans. on Circuit and Systems, vol. 35, no. 5, pp. 566-570, May 1988; and (3) "An improved search algorithm for the design of multiplierless FIR filters with powers-of-two coefficients" by Henry Samueli, IEEE Trans., on Circuit and Systems, vol. 36, no. 7, pp. 1044-1047, July 1989.

In reference (1), an optimum conversion is performed by obtaining optimized real coefficients, quantizing them, and using "a mixed integer linear programming algorithm".

In reference (2), to overcome the problems involved in the optimization technique of reference (1) of too long a calculation time and the limitation of a convertible filter length to approximately 40 taps, a quasi-optimum algorithm is suggested for simultaneously utilizing the time domain and the frequency domain, to thereby perform an optimum conversion.

In reference (3), the algorithm of reference (2) is improved by using an optimum scaling factor and a local bivariate search algorithm, and the number L of non-zero digits is increased to compensate quantization errors produced during a conversion of real coefficients into initial CSD coefficients. As suggested in reference (3), when a filter coefficient is 0.5 or above, additional allocation of non-zero digits basically increases the number of bits and makes hardware so complicated in an adaptive filter or a polyphase filter that the hardware cannot be used, even though it may be useful for a fixed type filter.

The optimization algorithms described in the above references require many calculations and cannot be applied to an adaptive filter and a polyphase filter, since conversions are based on ripples of a pass band and a stop band in the frequency domain.

Moreover, the algorithms are difficult to apply to a filter in which a coefficient conversion is not available by ripple of the frequency domain. For example, the algorithms cannot be applied to an equalizing filter for removing ghost or a ghost-removing filter. Therefore, for these filters, real coefficients are converted into CSD coefficients by utilizing the amount of remaining ghost.

In addition, with the optimization techniques suggested in the above references, a limitation of a CSD code having non-uniform characteristics cannot be overcome, since assigning a single scaling factor to all filter coefficients is inefficient and lowers the performance of a filter.

The present invention is intended to circumvent or reduce the above problems. It is an aim of embodiments of the present invention to provide a method for processing a signal in a CSD filter, in which real coefficients are directly converted into filter coefficients expressed in CSD codes in the time domain without an optimized conversion in the frequency domain.

It is another aim to provide a method for processing a signal in a CSD filter, in which the number of scaling factors are adjusted to increase the resolution of the scale factors without increasing a predetermined number of non-zero digits the resolution of the scaling factors, and which can be adapted to many kinds of filters.

It is still another aim to provide a method for processing a signal in a CSD filter, in which real coefficients are converted into CSD coefficients by grouped scaling factors obtained by a partial optimization of real coefficients.

It is yet another aim to provide a method for processing a signal in a CSD filter, in which CSD coefficients converted by a plurality of scaling factors are processed by a plurality of inverse-scaling factors corresponding to the plurality of scaling factors, respectively.

It is a further aim to provide a CSD filter circuit suitable for the above methods for processing a signal in a CSD filter.

According to a first aspect of the invention, there is provided a method for processing a signal in a CSD filter having desired filter characteristics obtained by filter coefficients expressed in CSD codes, the method comprising the steps of:

(a) obtaining real coefficients optimized to said filter characteristics;

(b) generating a plurality of scaling factors by calculating scaling factors for each real coefficient, which minimizes an error between said real coefficients and CSD-code-converted coefficients obtained by multiplying said real coefficients by a predetermined gain;

(c) producing CSD coefficients by using said plurality of scaling factors; and

(d) processing input data by using said CSD coefficients.

Preferably, said error of step (b) is minimized during conversion of the real coefficients into CSD codes, wherein said CSD coefficients produced in step (c) are optimum CSD coefficients and wherein said processing of step (d) comprises filtering of the input data.

Said step (c) may comprise the steps of:

(c1) converting real coefficients into first CSD coefficients by multiplying scaling factors by respective real coefficients; and

(c2) using an optimization algorithm based on the amount of ripple in the frequency domain to produce optimized second CSD coefficients from said first CSD coefficients.

The method may comprise the steps of:

in said step (b) the error minimized is an error between said real coefficients and CSD codes into which said real coefficients are converted;

in step (c) the CSD coefficients are produced by using said scaling factors for said each real coefficient;

and in said step (d), input data is multiplied by said CSD coefficients;

the method comprising the further step (e) of producing a final filter output by scaling the result of the multiplication in said step (d) by inverse-scaling factors which are the reciprocals of said scaling factors.

In said step (b), said scaling factors may be calculated so as to minimize the squared error sum between said real coefficients and CSD code-converted coefficients obtained by multiplying said real coefficients by a predetermined gain.

In said step (b) the scaling factors are preferably produced to minimize conversion errors between said real coefficients and CSD codes into which said real coefficients are converted; in said step (c) the CSD coefficients are preferably optimum CSD coefficients produced by using said plurality of scaling factors; and in said step (d) filtering of input data is preferably carried out by using said CSD coefficients.

In said step (c), said CSD coefficients may be produced in the time domain by multiplying said real coefficients by said plurality of scaling factors.

Said step (c) may comprise the steps of: (c1) converting said real coefficients into first CSD coefficients by multiplying said real coefficients by said plurality of scaling factors; and (c2) using an optimization algorithm based on the amount of ripple in the frequency domain to produce optimized second CSD coefficients from said first CSD coefficients.

The method may comprise, in said step (b), the scaling factors to minimize conversion errors between said real coefficients and CSD codes into which said real coefficients are converted; in said step (c), producing the CSD coefficients by converting said real coefficients into CSD codes using said plurality of scaling factors; and in said step (d), multiplying input data by said CSD coefficients; the method comprising a further step (e) of producing a final filter

**EP 0 766 388 B1**

output by scaling the result of the multiplication of said step (d) with a plurality of inverse-scaling factors which are the reciprocals of said plurality of scaling factors.

Said step (b) may comprise the steps of: (b1) grouping real coefficients of predetermined digits according to characteristics of CSD coefficients; and (b2) calculating scaling factors for each group which minimizes the squared error sum between said grouped real coefficients and most approximate CSD codes obtained by multiplying said grouped real coefficients by a predetermined gain.

Said step (b) may comprise the steps of: (b1') calculating scaling factors for each real coefficient, which minimizes the squared error sum between said real coefficients and most approximate CSD code-converted coefficients obtained by multiplying each real coefficient by a predetermined gain; and (b2') grouping said scaling factors calculated in said step (b1') for respective real coefficients in accordance with the similarity of said scaling factors in their values.

According to another aspect of the invention, there is provided an N-tap CSD filter circuit having desired filter characteristics by filter coefficients expressed in CSD codes, comprising:

N-1 unit delays connected in series for delaying input data;

a CSD coefficient generator for generating a plurality of scaling factors by calculating scaling factors for each real coefficient which minimizes an error between said real coefficients and CSD-code-converted coefficients obtained by multiplying said real coefficients obtained according to said filter characteristics by a predetermined gain, and for generating optimum CSD coefficients by using said calculated scaling factors;

N CSD multipliers for multiplying outputs of the N-1 unit delays by said CSD coefficients;

N inverse scalers for scaling the outputs of said N CSD multipliers with inverse-scaling factors which is the reciprocals of said scaling factors calculated for said real coefficients; and

an adder for adding the outputs of said N inverse scalers and producing a final filter output.

Each of said CSD multipliers preferably comprises:

shift matrices as many as the number L of non-zero digits in a CSD coefficient for shifting said input data according to each digit value of a CSD coefficient generated in said CSD coefficient generator;

L converters for converting the outputs of said L shift matrices into 2's complements; and

L-1 adders for adding the outputs of L converters.

If said CSD filter is an adaptive type, said shift matrix preferably comprises a barrel shifter.

If said CSD filter is a fixed type, said shift matrix preferably comprises a shifter.

Preferably, each of said L converters comprises an inverter and an adder for converting the output of a corresponding shift matrix into 2's complements only in a digit having "-1" of said CSD coefficient.

Each of said N inverse scalers may comprise shifters for shifting the output of each CSD multiplier according to the value of each inverse-scaling factor, and outputting the shifted result.

Each of N inverse scalers may comprise a CSD multiplier for multiplying the output of each CSD multiplier by each inverse-scaling factor.

Said CSD coefficient generator preferably includes:

a microprocessor for obtaining real coefficient according to said filter characteristics, and calculating scaling factors for said each real coefficient which minimizes errors between said real coefficients and most approximate CSD code-converted coefficients obtained by multiplying said real coefficients by a predetermined gain; and

a shifter for shifting said CSD code-converted coefficients and generating optimum CSD coefficients by using said scaling factors.

According to another aspect , there is provided an N-tap CSD filter circuit having desired filter characteristics by filter coefficients expressed in CSD codes, comprising:

N-1 unit delays connected in series for delaying input data;

a CSD coefficient generator for generating CSD coefficients by using a plurality (M) of scaling factors which minimize errors between said real coefficients and most approximate CSD code-converted coefficients obtained by multiplying said real coefficients by a predetermined gain;

N CSD multipliers for multiplying outputs of said N-1 unit delays by CSD coefficients generated through said M scaling factors;

M adders for adding the outputs of CSD multipliers which have multiplied the same scaling factor among the outputs of said N CSD multipliers;

M inverse scalers for scaling the outputs of said M adders with M inverse-scaling factors which are the reciprocals of said M scaling factors; and

an adder for adding the outputs of said M inverse scalers and producing a final filter output.

Preferably, said CSD coefficient generator groups real coefficients in predetermined digits according to characteristics of CSD coefficients, multiplies said grouped real coefficients by a predetermined gain, thus obtaining most approximate CSD code-converted coefficients, and calculates scaling factors for each group of real coefficients which minimize the sum of errors between said real coefficients and said CSD code-converted coefficients.

Said CSD coefficient generator preferably calculates scaling factors for each real coefficient which minimizes the sum of errors between said real coefficients and CSD code-converted coefficients obtained by multiplying said real coefficients by a predetermined gain, groups said scaling factors according to the similarity of said scaling factors in their values, and produces a plurality of scaling factors.

Each of said N CSD multipliers may comprise:

shift matrices as many as the number L of non-zero digits in a CSD coefficient for shifting input data in accordance with each digit value of a CSD coefficient generated from said CSD coefficient generator;

L converters for converting the outputs of said L shift matrices into 2's complements according to said CSD coefficient; and

L-1 adders for adding the outputs of said L converters.

Each of said M inverse scalers may comprise a shifter for shifting the output of each of said M adders according to the value of each of a plurality of inverse-scaling factors, and outputting the shifted result.

Each of said M inverse scalers may comprise a CSD multiplier for multiplying the output of each of said M adders by each of a plurality of inverse-scaling factors.

Preferably, said CSD coefficient generator includes:

a microprocessor for obtaining real coefficients according to said filter characteristics, multiplying said real coefficients by a predetermined gain, thus obtaining most approximate CSD code-converted coefficients, and calculating scaling factors for each real coefficient which minimizes errors between said real coefficients and said CSD code-converted coefficients; and

a shifter for shifting said CSD code-converted coefficients and generating optimum CSD coefficients by using said scaling factors.

For a better understanding of the invention, and to show how embodiments of the same may be carried into effect, reference will now be made, by way of example, to the accompanying diagrammatic drawings, in which:

Figure 1 illustrates distributions of CSD coefficients;

Figure 2 is a concept view for explaining a conventional method for processing a signal in a CSD filter;

Figure 3 is a circuit diagram of a CSD filter for implementing the method shown in Figure 2;

Figure 4 is a concept view for explaining a method for processing a signal in a CSD filter, according to an embodiment of the present invention;

Figure 5 is a circuit diagram of a CSD filter for implementing the method shown in Figure 4;

Figure 6 is a detailed diagram of a CSD multiplier shown in Figure 5;

Figure 7 is a concept view for explaining a method for processing a signal in a CSD filter, according to another embodiment of the present invention; and

Figure 8 is a circuit diagram of a CSD filter for implementing the method shown in Figure 7.

Preferred embodiments of a method for processing a signal in a CSD filter and a circuit suitable for the method, according to the present invention, will be described.

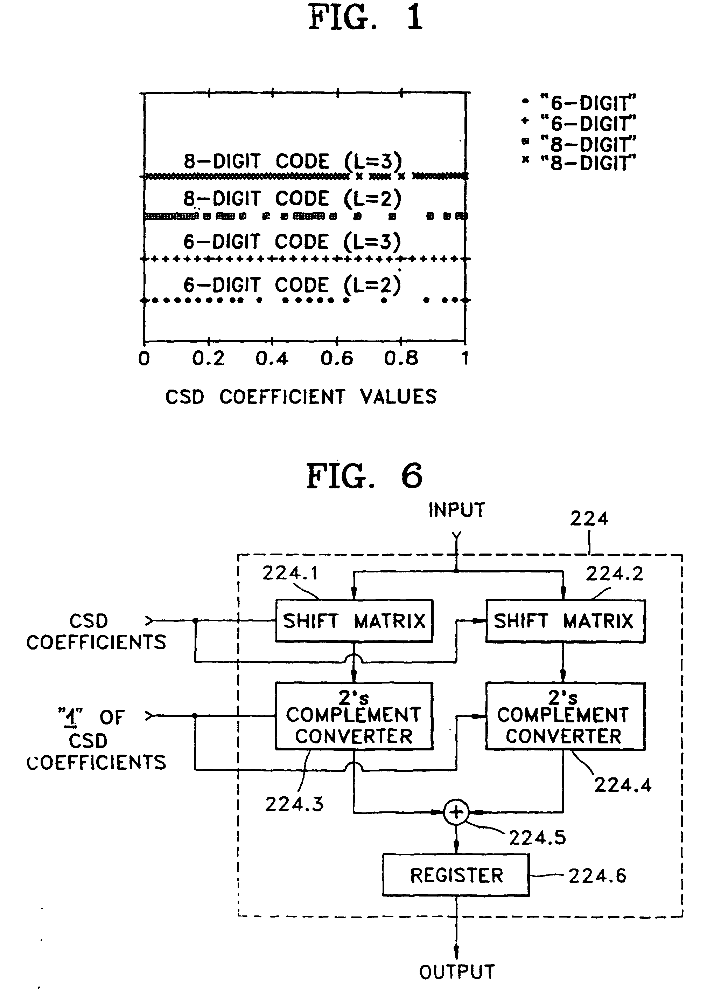

Referring to Figure 1, general characteristics of a CSD code are described below.

The CSD code has "-1" or "1" assigned to a fixed number of digits, and "0" assigned to the remaining digits. This CSD code X is expressed as

$$X = \sum_{k=1}^{L} S_k \, 2^{-P_k} \ldots \ldots \ldots (1)$$

where a coefficient having a kth digit value, $S_k \in \{-1, 0, 1\}$, $P_k \in \{0, 1, ..., M\}$, M indicates the number of all digits, and L indicates the number of digits not having "0" (hereinafter, referred to as non-zero digits). That is, the number of digits having "-1" or "1", namely, a non-zero value is L or smaller. The CSD expression is defined as a minimum expression in which arbitrary two coefficients $S_k$ having non-zero values are not adjacent to each other.

For example, 127/128, which equals to 0.9921875, is calculated into "0.1111111" in general binary code, thus having seven non-zero digits. Being represented in a CSD code with "L=2", this value is as "1.0000001". Here, 1 indicates "-1".

An advantage of the CSD code over a general radix-2 binary code is that it can be expressed with fewer non-zero digits due to the flexibility derived from negative digits.

In a filter employing filter coefficients expressed in CSD codes (hereinafter, referred to as "CSD coefficients"), the number of addition/subtraction operations needed for a multiplication can be reduced by limiting L. That is, in the filter using CSD coefficients, since the coefficients have "-1" or "1" in a fixed number of digits, a CSD multiplier can be configured with shifters as many as L and adders/subtractors as many as L-1. Therefore, the number of adders/subtractors needed for each multiplier in the filter can be one smaller than L by one. As a result, the size of hardware of the digital filter can be reduced.

Figure 1 illustrates distributions of CSD coefficients set for 6- and 8-digit codes with 2 and 3 non-zero digits, where (6-digit) represents a case of L=2 and M=6, +(6-digit) represents that of L=3 and M=6, □ (8-digit) represents that of L=2 and M=8, and X(8-digit) represents that of L=3 and M=8. As shown in Figure 1, the distributions of the CSD coefficients are not uniform and the CSD coefficients are concentrated in an area where a CSD coefficient has a small value. The smaller M and L are, the less uniform the distribution of CSD coefficients is. However, since the frequency of calculations in a filter is increased with larger M and L, a CSD coefficient conversion which is effective and makes M and L smaller is required.

In a CSD filter having these characteristics, a real-numbered real filter coefficient (hereinafter, referred to as a "real coefficient") is not directly converted into a CSD coefficient. Instead, the real coefficient is multiplied by a scaling factor for readjusting the magnitude of the real coefficient, and then converted into the CSD coefficient. In this way, a real coefficient having a relatively large value in an area of a relatively low distribution density of CSD coefficients is converted into a CSD coefficient having a relatively small value in an area of a relatively high distribution density of CSD coefficients when the scale factor is smaller than 1.

The premise for use of a scaling factor is that despite assignment of a predetermined gain to a converted coefficient and a real coefficient, both the coefficients have the same normalized-frequency characteristics. That is, the real coefficient can be converted into the CSD coefficient by using the scaling factor, because a gain of a filter has no influence on the frequency characteristics of the filter.

However, the gain of the filter may be increased or decreased when the real coefficient is converted into the CSD coefficient by the scaling factor. This problem of gain change can be reduced by multiplying the CSD coefficient by an inverse-scaling factor which is the a reciprocal of the scaling factor. Quantization errors (hereinafter, referred to as "conversion errors") produced during the conversion of the real coefficient into the CSD coefficient can be reduced by scaling factor processing and inverse-scaling factor processing.

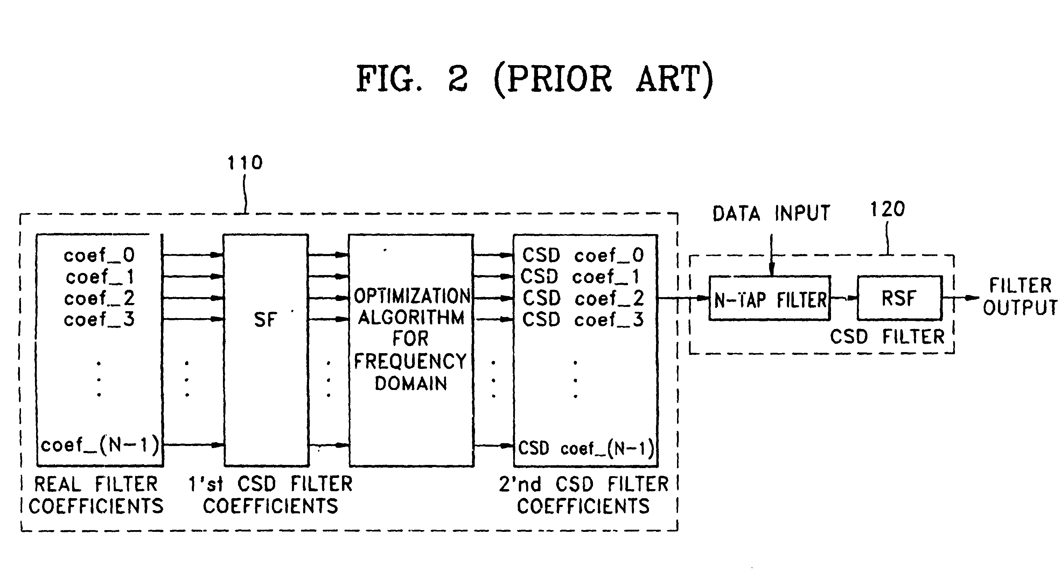

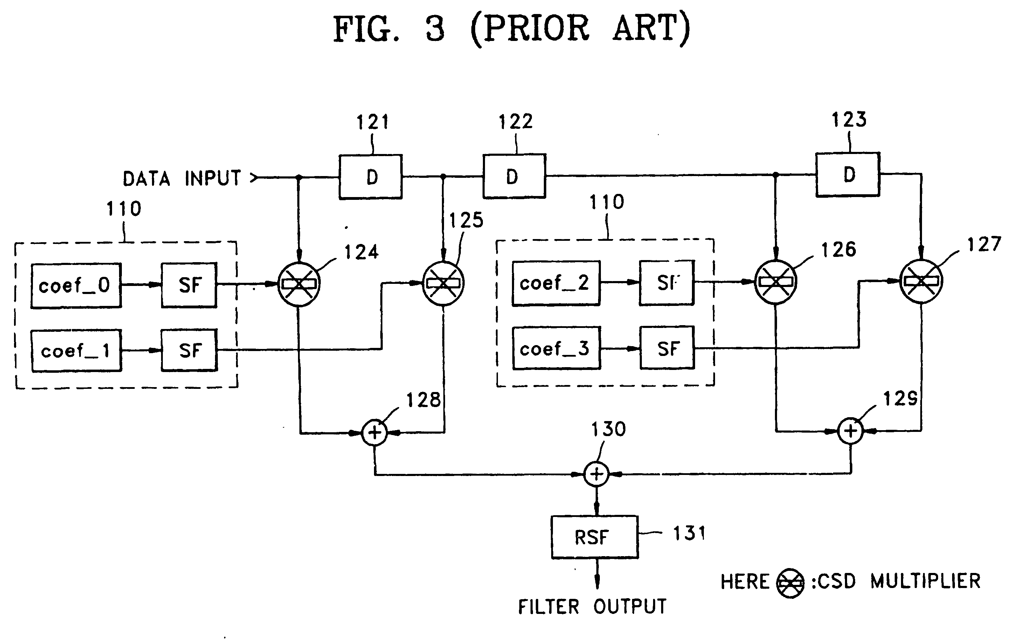

Referring to FIGs. 2 and 3, a conventional method for utilizing a scaling factor and a circuit therefor will be described.

In general, the output y(n) of an N-tap filter with respect to an input signal x(n) is given by

$$y(n) = \sum_{k=0}^{N-1} x(n-K)h(k) \ldots\ldots\ldots (2)$$

A scaling factor in the conventional method is chosen to minimize an error given by the following equations (3) and (4), between a real coefficient h(n) and its most approximate CSD code $\bar{h}(n)$ obtained by multiplying a gain A by real coefficient h(n).

$$E(A) = \sum_{k=0}^{N-1} (h(n) - \bar{h}(n)/A)^2 \ldots\ldots\ldots (3)$$

$$\bar{h}(n) = [A \cdot h(n)] \tag{4}$$

where [ ] implies a CSD conversion in which real coefficient h(n) is simply quantized into the most approximate of given CSD codes.

As described above, a scaling factor is widely used in CSD applications, since conversion errors resulting from non-uniform characteristics of a CSD code are decreased by adding a predetermined gain using the scaling factor, under the premise that frequency characteristics undergo no change in spite of the addition of the gain of the filter by the scaling factor.

Figure 2 is a concept view for a conventional method for processing a signal in a filter by using a scaling factor given by equations (3) and (4).

In Figure 2, the block 110 represents operations performed in a CSD coefficient generator. If coefficients of a CSD filter are fixed, a general-purpose microprocessor or a controller having a sufficient calculation capability is used for the calculations. A CSD filter 120 is built on the basis of CSD multipliers, adders and so on.

The signal processing method shown in Figure 2 will be described in STEP 1-STEP 6.

STEP 1: N optimum real coefficients (coef_0-coef_(N-1)) are obtained using a filter design algorithm (or tool) according to the corresponding filter function, e.g., high-pass filtering or low-pass filtering.

STEP 2: a single scaling factor is calculated using equations (3) and (4) for a predetermined L, and the N real coefficients are converted into their most approximate CSD coefficients (first CSD coefficients) by the single scaling factor.

STEP 3: an optimization algorithm in the frequency domain based on the amount of ripple is used.

STEP 4: optimized CSD coefficients (second CSD coefficients: CSD coef_0-CSD coef_(N-1)) are produced from the first CSD coefficients by the optimization algorithm.

STEP 5: the optimized CSD coefficients are multiplied by input data in a CSD multiplier (this operation is referred as "CSD multiplication").

STEP 6: a final filter output is produced by operating the result of the multiplication in STEP 5 with a single inverse-scaling factor which is a reciprocal of the scaling factor weighting.

The optimization algorithm used in the method shown in Figure 2 is accompanied by the weighting calculations and a long calculation time, since ripple of frequency characteristics is used as a variable.

Further, the above method is difficult to use when an optimization method for the frequency domain is not available, as in an adaptive filter and a polyphase filter, or when conversion characteristics are not found out on the basis of the amount of ripple, as in a ghost-removing filter and a equalizing filter for removing ghost.

Figure 3 is a circuit diagram of a 4-tap CSD filter for implementing the method shown in Figure 2.

In Figure 3, the 4-tap CSD filter is comprised of three unit delays 121-123 connected in series for delaying input data, a first CSD multiplier 124 for multiplying a CSD coefficient coef_0 by the input data, a second CSD multiplier 125 for multiplying the output of first unit delay 121 by a CSD coefficient coef_1, a third CSD multiplier 126 for multiplying the output of second unit delay 122 by a CSD coefficient coef_2, a fourth CSD multiplier 127 for multiplying the output of third unit delay 123 by a CSD coefficient coef_3, a first adder 128 for adding the outputs of first and second CSD multipliers 124 and 125, a second adder 129 for adding the outputs of third and fourth CSD multipliers 126 and 127, a third adder 130 for adding the outputs of first and second adders 128 and 129, and an inverse scaler 131 for scaling the output of third adder 130 with a single inverse-scaling factor.

In FIG 3, the CSD coefficient generator 110 is drawn divided into two parts for simplicity's sake. As described in reference with Figure 2, the CSD coefficients coef_0 through coef_3 output from CSD coefficient generator 110 are second CSD coefficients obtained by converting the real coefficients into their most approximate CSD coefficients by the scaling factor and optimizing in the frequency domain. The reverse-scaling factor is the reciprocal of the scaling factor.

The 4-tap CSD filter circuit according to the conventional method shown in Figure 3 has problems in that it takes much time to convert a real coefficient into a CSD coefficient in CSD coefficient generator 110 and a conversion performance is not so good due to initial conversion errors involved in the choice of a scaling factor.

Therefore, to overcome the problems of the conventional converting method in a CSD filter, the present inventor suggests a converting method sufficiently effective just through a conversion in the time domain with respect to a predetermined number of non-zero digits, by using a plurality of scaling factors and a plurality of inverse-scaling factors in accordance with characteristics of CSD coefficients. This suggested method effectively removes or disperses conversion errors resulting from non-uniform characteristics by the plurality of scaling factors, thus making signal processing by CSD coefficients useful. In addition, a scaling factor processing itself is used for the conversion optimization in embodiments of the present invention, whilst scaling factor processing serves as pre-filtering for a conversion optimization in embodiments of the frequency domain in a conventional CSD filter. Therefore, the step of conversion optimization is not required, and the calculation time can be reduced.

Then, a method for converting a real coefficient into a CSD coefficient by controlling a scaling factor in the time domain, according to embodiments of the present invention will be described.

A real coefficient must be converted into its approximate CSD coefficient in a filter designed to have desired characteristics.

For this purpose, equations (3) and (4) are modified into equations (5) and (6), so that a scaling factor is assigned to each filter coefficient (real coefficient).

Theoretically, h(n) can be equal to $\bar{h}(n)$ perfectly even in the case of L=1, when separate scaling factors and inverse-scaling factors are assigned to each filter coefficient.

Therefore, a CSD coefficient conversion for improving conversion performance without increasing L is possible by assigning at least one scaling factor/inverse-scaling factor to each filter coefficient, that is, increasing the resolution of scaling factors.

$$E(A) = \sum_{k=0}^{N-1} (h(n) - \bar{h}(n)/A_n)^2 \ldots\ldots\ldots (5)$$

$$\bar{h}(n) = [A_n \cdot h(n)] \qquad (6)$$

Here, the scaling factors assigned to each real coefficient h(n) are varied and adjusted so that the squared error sum between real coefficients h(n) and their most approximate CSD codes obtained by equation (5) is the minimum value. With increase in the resolution of the scaling factors, the value of E(A) becomes much smaller than that of the conventional method. This method obviates the need for optimization in the frequency domain, thus remarkably reducing the calculation burdens and a calculation time.

If $A_0 = A_1 = ,..., = A_{N-2} = A_{N-1} = A$ in equations (5) and (6), equations (5) and (6) produce the same result as that of equations (3) and (4).

Equations (5) and (6) can be modified as follows, to minimize an error for each coefficient.

$$E(A_n) = (h(n) - \bar{h}(n) / A_n)^2 \qquad (7)$$

$$\bar{h}(n) = [A_n \cdot h(n)]$$

where n=0, 1, 1, ..., N-1.

From the modified equation (7), scaling factors which minimize $E(A_k)$ for each coefficient, respectively, are obtained and applied. Therefore, a perfect conversion of a real coefficient into a CSD coefficient is possible. That is,

$$\sum_{k=1}^{N-1} E(A_n) \approx 0 \ldots\ldots\ldots (8)$$

In practice, it is likely that scaling factors and inverse-scaling factors are not real numbers but take power-of-two or CSD forms. Nevertheless, approximate values are obtained in equation (8).

In the conventional method, the scaling factors of all coefficients have the same value, that is, SF_1=SF_2=,..., =SF_n=SF(=A).

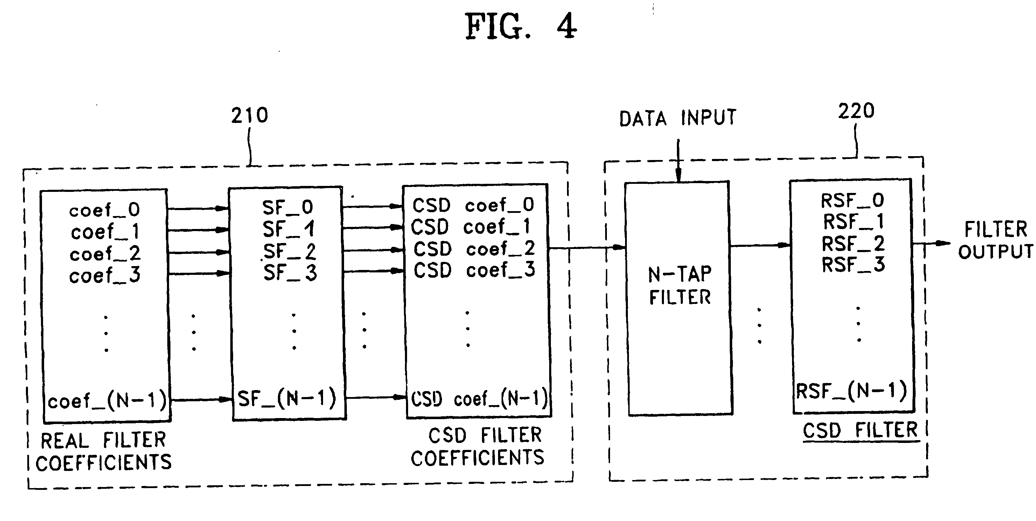

A method for processing a signal in a CSD filter according to principles of the present invention is conceptually illustrated in Figure 4.

In Figure 4, the block 210 represents operations performed in a CSD coefficient generator. A general-purpose microprocessor or a controller having a sufficient calculation capability can be used for the calculations. A CSD filter 220 is built on the basis of CSD multipliers, adders, and so on.

The signal processing method shown in Figure 4 will be described in STEP 11-STEP 15.

STEP 11: N optimum real coefficients (coef_0-coef_(N-1)) are obtained using a filter design tool according to the corresponding filter function.

STEP 12: scaling factors (SF_0-SF_(N-1)) for respective real coefficients are calculated using equations (6) and (7), for a predetermined number L of non-zero digits.

STEP 13: using the calculated scaling factors, the real coefficients are converted into their most approximate CSD codes, which are optimum CSD coefficients (CSD coef_0-CSD coef_(N-1)).

STEP 14: input data are CSD-multiplied by the converted optimum CSD coefficients.

STEP 15: the results of the multiplication of STEP 14 are scaled with N inverse-scaling factors (RSF_0-RSF_(N-1)) which are reciprocals of the scaling factors obtained in STEP 12 to produce a final filter output.

Therefore, the method shown in Figure 4 for obtaining CSD coefficients obviates the need for optimization in the frequency domain which the conventional method requires. Thus, the calculation burdens and calculation time can be remarkably reduced.

The present invention can reduce initial conversion errors due to incorrect scaling factors by means of a local search algorithm used in the reference (2). Since embodiments of the present invention improve calculation speed and conversion performance, the principles can be applied to a polyphase filter and an adaptive filter employing variable filter coefficients as well as a fixed type filter using fixed filter coefficients.

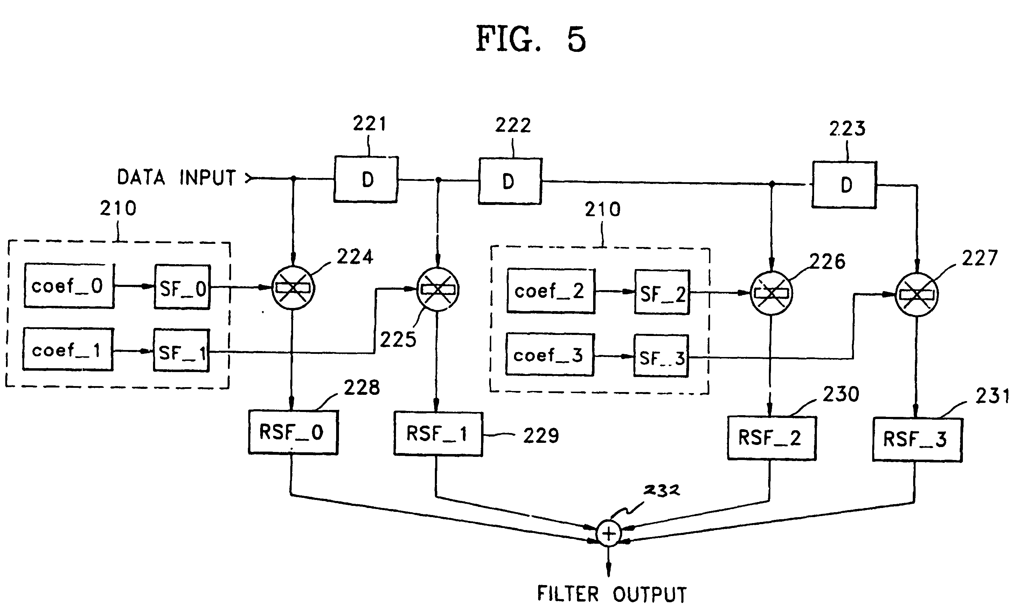

Figure 5 is a circuit diagram of a 4-tap CSD filter implementing the method shown in Figure 4.

In Figure 5, the 4-tap CSD filter is comprised of three unit delays connected in series 221-223 for delaying input data, a first CSD multiplier 224 for multiplying a CSD coefficient coef_0 by the input data, a CSD multiplier 225 for multiplying the output of first unit delay 221 by a CSD coefficient coef_1, a third CSD multiplier 226 for multiplying the output of second unit delay 222 by a CSD coefficient coef_2, a fourth CSD multiplier 227 for multiplying the output of third unit delay 223 by a CSD coefficient coef_3, first through fourth inverse scalers 228-231 for scaling the outputs of first through fourth multipliers 224-227 by the first through fourth inverse scaling factors, and an adder 232 for adding the outputs of first through fourth inverse scalers 228-231 to produce a final filter output.

Here, as described in reference with Figure 4, the CSD coefficients coef_0 through coef_3 output from CSD coefficient generator 210 are those obtained by converting the real coefficients produced according to the filter characteristics, by means of the first through fourth scaling factors calculated from equations (6) and (7).

CSD coefficient generator 210 may be comprised of a microprocessor for obtaining a real coefficient according to the filter characteristics, multiplying the real coefficient by a gain into its approximate CSD code, and calculating a scaling factor for each real coefficient, which minimizes an error between the real coefficient and the converted CSD code, and a shifter for shifting the CSD code-converted coefficient so as to generate an optimum CSD coefficient in case that the scaling factor can be expressed by $2^{-SF}$. This shifter may be replaced by a CSD multiplier.

Further, inverse scalers 228-231 may be comprised of shifters for shifting the outputs of multipliers 224-227 by inverse-scaling factors, or CSD multipliers for multiplying the outputs of multipliers 224-227 by the inverse-scaling factors.

Here, when the calculation of the scaling factors is performed by shifters, there is no need for an additional hardware since the calculation of the inverse-scaling factors is performed by the shifters, either. At this time, the scaling factor and the inverse scaling factor are expressed by $2^{-SF}$.

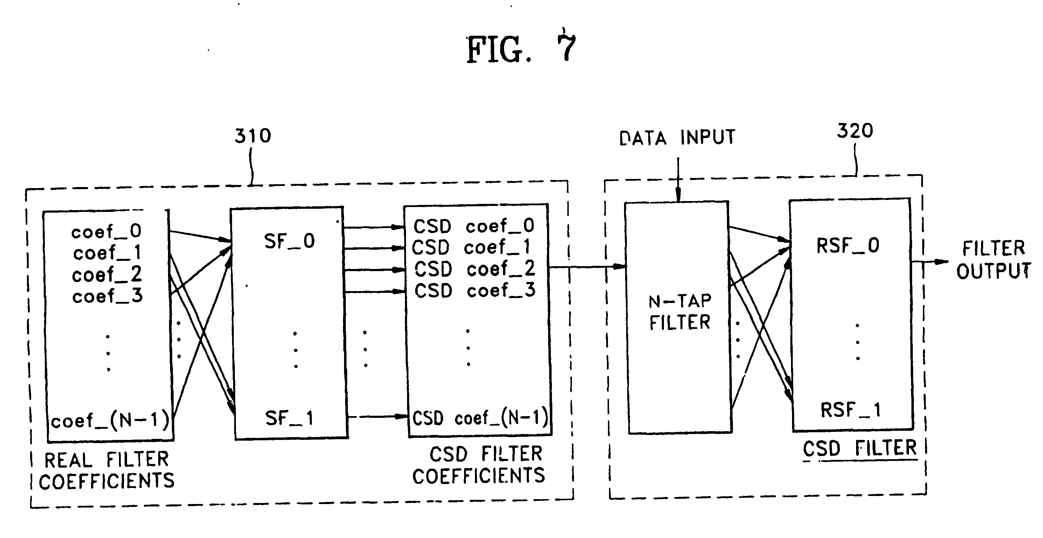

A CSD multiplier can be comprised of shifters as many as L and adders/subtractors as many as L-1, as shown in Figure 6. Figure 6 shows first multiplier 224, given L=2.

Referring to Figure 6, CSD multiplier 224 is comprised of two shift matrices 224.1 and 224.2 for receiving input data, shifting the input data according to the value of a CSD coefficient, and outputting the result, two 2's complement converters 224.3 and 224.4 for converting the outputs of shift matrices 224.1 and 224.2 into 2's complements, given "1" of a CSD coefficient generated from CSD coefficient generator 220, and an adder 224.5 for adding the outputs of 2's complement converters 224.3 and 224.4. Here, a register 224.6 operating only in a high speed mode may be additionally connected to the output terminal of adder 224.5. Further, if the CSD filter is an adaptive type, a shift matrix may be replaced by a barrel shifter. If it is a fixed type, the shift matrix may be replaced by a shifter which simply manipulates connection between an input and a 2's complement converter. The 2's complement converter can be comprised of an inverter and an adder. And for an addition, adder 224.5 and carry inputs of adder between taps can be used.

The operation of the CSD multiplier shown in Figure 6 will be described. Shift matrices 224.1 and 224.2 shift stored data according to the value of a CSD coefficient generated from CSD coefficient generator 210. 2's complement converters 224.3 and 224.4 convert the outputs of shift matrix 224.1 and 224.2 into 2's complements, given "1" of a CSD coefficient, whilst they do not respond to "1" or "0" thereof. Adder 224.5 adds the outputs of 2's complement converters 224.3 and 224.4.

If scaling factors minimizing errors and inverse-scaling factors are assigned to respective real coefficients as described above, however, the size of hardware is increased even though calculations are fast and conversion performance is improved. Therefore, it is necessary to limit the resolution of scaling factors in consideration of the magnitude of hardware, in a practical application. Thus, the scaling factors for respective filter coefficients need to be grouped in accordance with their proximity. On the other hand, if the calculation of the scaling factors/inverse-scaling factors is performed only by shifters, the magnitude of hardware is not increased.

In another embodiment of the present invention, scaling factors can be grouped into fewer numbers by categorizing them according to the position of filter coefficients or according to the similarities in their size, to limit their resolution.

That is, in the former case, the same scaling factors are assigned to real coefficients in a predetermined digit. This can be usefully applied to a polyphase filter. In the latter case, a combination of scaling factors which minimizes E(A) is chosen among combinations of scaling factors in which similar scaling factors are grouped into the same one.

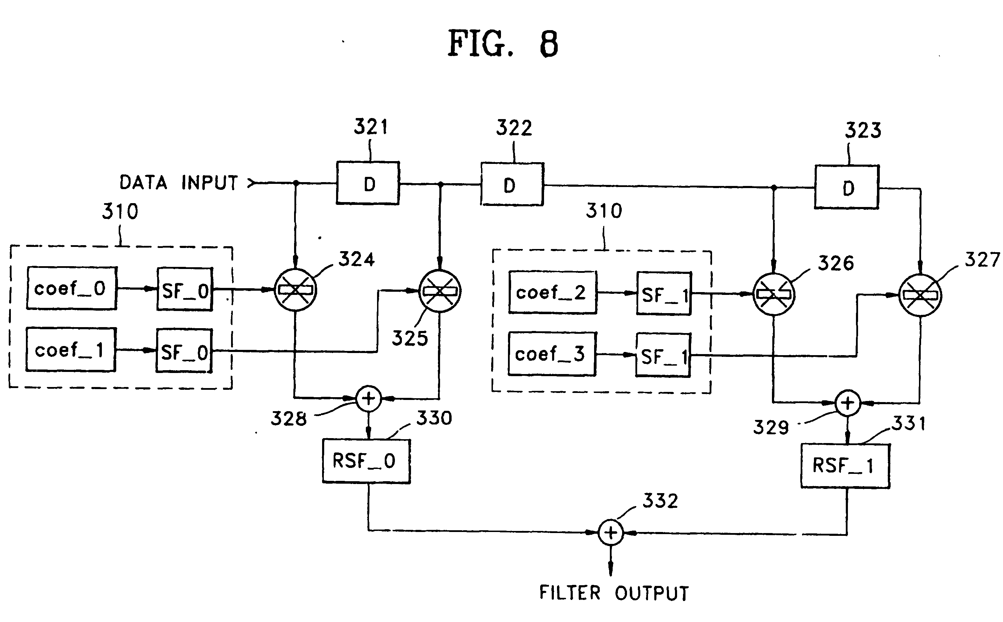

Figure 7 is a concept view of a method for processing a signal in a filter with two scaling factors, according to the embodiment of the present invention.

Referring to Figure 7, the block 310 represents operations performed in a CSD coefficient generator. A general-purpose microprocessor or a controller can be used for the calculations having a sufficient calculation capability. A CSD filter 320 is built on the basis of CSD multipliers, adders, and so on.

The signal processing method shown in Figure 7 is described in STEP 21 through STEP 25.

STEP 21: N real coefficients (coef_0-coef_(N-1)) are obtained using a filter design tool according to the characteristics of a corresponding filter.

STEP 22: a predetermined number of (here, two) scaling factors (SF_0 and SF_1) are calculated by assigning the same scaling factor to coefficients in a predetermined digit or grouping scaling factors for real coefficients in accordance with their similarities, according to characteristics of CSD coefficients. The scaling factors are calculated by equations (5) and (6).

STEP 23: the real coefficients are converted into CSD codes by the two scaling factors obtained by the grouping. These CSD codes are optimum CSD coefficients (CSD coef_0-CSD coef_(N-1)).

STEP 24: the input data are CSD-multiplied by the optimized CSD coefficients.

STEP 25: the results of the multiplication of STEP 24 are scaled with two inverse-scaling factors (RSF_0 and RSF_2) which are reciprocals of the scaling factors obtained in STEP 22, respectively, to produce a final filter output.

The overall performance of a filter can be improved if scaling factors are grouped as shown in Figure 7, for example, assigning a separate scaling factor to each filter group in a polyphase filter.

In addition, conversion performance can be further improved if real coefficients are converted into first CSD coefficients by a plurality of scaling factors, and then optimized CSD coefficients are generated using an optimization algorithm on the basis of ripple in the frequency domain, as in the conventional CSD filter.

Figure 8 is a circuit diagram of a 4-tap CSD filter for implementing the method shown in Figure 7.

In Figure 8, the 4-tap CSD filter is comprised of three unit delays 321-323 connected in series for delaying input data, a first CSD multiplier 324 for multiplying a CSD coefficient coef_0 by the input data, a second CSD multiplier 325 for multiplying the output of first unit delay 321 by a CSD coefficient coef_1, a third CSD multiplier 326 for multiplying the output of second unit delay 322 by a CSD coefficient coef_2, a fourth CSD multiplier 327 for multiplying the output of third unit delay 323 by a CSD coefficient coef_3, a first adder 328 for adding the outputs of first and second CSD multipliers 324 and 325, a second adder 329 for adding the outputs of third and fourth multipliers 326 and 327, a first inverse scaler 330 for scaling the output of first adder 328 with a first inverse-scaling factor, a second inverse scaler 331 for scaling the output of second adder 329 with a second inverse-scaling factor, and an adder 332 for adding the outputs of first and second inverse scalers 330 and 331 to output a final filter output.

Here, the CSD coefficients coef_0 through coef_3 are those obtained by converting the first through fourth real coefficients produced according to the filter characteristics by means of the first and second scaling factors which are grouped according to characteristics of CSD coefficients as described above. The first and second inverse-scaling factors are the reciprocals of the first and second scaling factors, respectively.

In Figure 5 showing an ideal embodiment of the present invention, an RSF is involved in every coefficient calculation, and thus hardware may be increased. However, if the calculation is performed by shifters, there is no increase in hardware, coefficient conversion is rapid, and conversion performance is excellent because of the high resolution of scaling factors.

Meanwhile, Figure 8 shows an embodiment in which the resolution of scaling factors is limited to a predetermined number, to reduce the size of hardware. Here, RSF calculations in a real filter are substantially decreased as compared with an ideal case of Figure 5.

That is, in the present invention, performance has a trade-off relationship with hardware complexity by a scaling factor resolution.

Further, when scaling of scaling factors or inverse-scaling factors are performed only by shifters, increase in the size of hardware is prevented even though conversion performance may be slightly restricted.

Embodiments of the present invention reduces conversion errors caused by differences between filter coefficients by using at least two scaling factors, whilst the conventional method uses a single scaling factor for all real coefficients. In addition, conversion performance is improved by increasing a scale resolution while reference (3) reduces conversion errors with bit resolution.

As described above, the method according to the present invention improves the processing speed by converting a real coefficient into a CSD coefficient in the time domain instead of processing in the frequency domain. Further, the present invention can be applied to many types of filters such as an adaptive filter or a polyphase filter, by increasing bit resolution with a fixed number of non-zero digits.

### Claims

1. A method for processing a signal in a CSD filter having desired filter characteristics obtained by filter coefficients expressed in CSD codes, the method comprising the steps of:

   (a) obtaining real coefficients optimized to said filter characteristics;

   (b) generating a plurality of scaling factors by calculating scaling factors for each real coefficient, which minimizes an error between said real coefficients and CSD-code-converted coefficients obtained by multiplying said real coefficients by a predetermined gain;

   (c) producing CSD coefficients by using said plurality of scaling factors; and

   (d) processing input data by using said CSD coefficients.

2. A method according to claim 1, wherein said error of step (b) is minimized during conversion of the real coefficients into CSD codes, wherein said CSD coefficients produced in step (c) are optimum CSD coefficients and wherein said processing of step (d) comprises filtering of the input data.

3. A method for processing a signal in a CSD filter as claimed in claim 1 or 2, wherein said step (c) comprises the steps of:

   (c1) converting real coefficients into first CSD coefficients by multiplying scaling factors by respective real coefficients; and

   (c2) using an optimization algorithm based on the amount of ripple in the frequency domain to produce optimized second CSD coefficients from said first CSD coefficients.

4. A method for processing a signal in a CSD filter as claimed in claim 1, wherein:

   in said step (b) the error minimized is an error between said real coefficients and CSD codes into which said real coefficients are converted;

in step (c) the CSD coefficients are produced by using said scaling factors for said each real coefficient;

and in said step (d), input data is multiplied by said CSD coefficients;

the method comprising the further step (e) of producing a final filter output by scaling the result of the multiplication in said step (d) by inverse-scaling factors which are the reciprocals of said scaling factors.

5. A method for processing a signal in a CSD filter, as claimed in any of the preceding claims, wherein in said step (b), said scaling factors are calculated so as to minimize the squared error sum between said real coefficients and CSD code-converted coefficients obtained by multiplying said real coefficients by a predetermined gain.

6. A method according to claim 1, wherein:

in said step (b) the scaling factors are produced to minimize conversion errors between said real coefficients and CSD codes into which said real coefficients are converted;

in said step (c) the CSD coefficients are optimum CSD coefficients produced by using said plurality of scaling factors; and

in said step (d) filtering of input data is carried out by using said CSD coefficients.

7. A method as claimed in any of claims 1, 2 or 6, wherein in said step (c), said CSD coefficients are produced in the time domain by multiplying said real coefficients by said plurality of scaling factors.

8. A method for processing a signal in a CSD filter as claimed in claim 6 or 7, wherein said step (c) comprises the steps of:

(c1) converting said real coefficients into first CSD coefficients by multiplying said real coefficients by said plurality of scaling factors; and

(c2) using an optimization algorithm based on the amount of ripple in the frequency domain to produce optimized second CSD coefficients from said first CSD coefficients.

9. A method according to claim 1, wherein in said step (b), the scaling factors are calculated to minimize conversion errors between said real coefficients and CSD codes into which said real coefficients are converted;

in said step (c), the CSD coefficients are produced by converting said real coefficients into CSD codes using said plurality of scaling factors; and

in said step (d), input data is multiplied by said CSD coefficients;

the method comprising a further step (e) of producing a final filter output by scaling the result of the multiplication of said step (d) with a plurality of inverse-scaling factors which are the reciprocals of said plurality of scaling factors.

10. A method for processing a signal in a CSD filter as claimed in claim 6, 7, 8 or 9, wherein said step (b) comprises the steps of:

(b1) grouping real coefficients of predetermined digits according to characteristics of CSD coefficients; and

(b2) calculating scaling factors for each group which minimizes the squared error sum between said grouped real coefficients and most approximate CSD codes obtained by multiplying said grouped real coefficients by a predetermined gain.

11. A method as claimed in claim 6, 7, 8 or 9, wherein said step (b) comprises the steps of:

(b1') calculating scaling factors for each real coefficient, which minimizes the squared error sum between said real coefficients and most approximate CSD code-converted coefficients obtained by multiplying each real coefficient by a predetermined gain; and

(b2') grouping said scaling factors calculated in said step (b1') for respective real coefficients in accordance with the similarity of said scaling factors in their values.

12. An N-tap CSD filter circuit having desired filter characteristics by filter coefficients expressed in CSD codes, comprising:

N-1 unit delays (221-223) connected in series for delaying input data;

a CSD coefficient generator (210) for generating a plurality of scaling factors by calculating scaling factors for each real coefficient which minimizes an error between said real coefficients and CSD-code-converted coefficients obtained by multiplying said real coefficients obtained according to said filter characteristics by a predetermined gain, and for generating optimum CSD coefficients by using said calculated scaling factors;

N CSD multipliers (224-227) for multiplying outputs of the N-1 unit delays (221-223) by said CSD coefficients;

N inverse scalers (228-231) for scaling the outputs of said N CSD multipliers (224-227) with inverse-scaling factors which is the reciprocals of said scaling factors calculated for said real coefficients; and

an adder (232) for adding the outputs of said N inverse scalers and producing a final filter output.

13. A CSD filter circuit as claimed in claim 12, wherein each of said CSD multipliers (224-227) comprises:

shift matrices (224.1, 224.2) as many as the number L of non-zero digits in a CSD coefficient for shifting said input data according to each digit value of a CSD coefficient generated in said CSD coefficient generator, 210;

L converters (224.3, 224.4) for converting the outputs of said L shift matrices (224.1, 224.2) into 2's complements; and

L-1 adders (224.5) for adding the outputs of L converters.

14. A CSD filter circuit as claimed in claim 13, wherein said CSD filter is an adaptive type, and said shift matrix (224.1, 224.2) comprises a barrel shifter.

15. A CSD filter circuit as claimed in claim 13, wherein said CSD filter is a fixed type and said shift matrix (224.1, 224.2) comprises a shifter.

16. A CSD filter circuit as claimed in claim 13, 14 or 15, wherein each of said L converters (224.3, 224.4) comprises an inverter and an adder for converting the output of a corresponding shift matrix into 2's complements only in a digit having "-1" of said CSD coefficient.

17. A CSD filter circuit as claimed in any of claims 12 to 16, wherein each of said N inverse scalers (228-231) comprises shifters for shifting the output of each CSD multiplier (224-227) according to the value of each inverse-scaling factor, and outputting the shifted result.

18. A CSD filter circuit as claimed in any of claims 12 to 16, wherein each of N inverse scalers (228-231) comprises a CSD multiplier for multiplying the output of each CSD multiplier by each inverse-scaling factor.

19. A CSD filter circuit as claimed in any of claims 12 to 16, wherein said CSD coefficient generator (210) includes:

a microprocessor for obtaining real coefficient according to said filter characteristics, and calculating scaling factors for said each real coefficient which minimizes errors between said real coefficients and most approximate CSD code-converted coefficients obtained by multiplying said real coefficients by a predetermined gain; and

a shifter for shifting said CSD code-converted coefficients and generating optimum CSD coefficients by using said scaling factors.

20. An N-tap CSD filter circuit having desired filter characteristics by filter coefficients expressed in CSD codes, comprising:

N-1 unit delays (321-323) connected in series for delaying input data;

a CSD coefficient generator (310) for generating CSD coefficients by using a plurality Mof scaling factors which minimize errors between said real coefficients and most approximate CSD code-converted coefficients obtained by multiplying said real coefficients by a predetermined gain;

N CSD multipliers (324-327) for multiplying outputs of said N-1 unit delays by CSD coefficients generated through said M scaling factors;

M adders (328-329) for adding the outputs of CSD multipliers (324-327) which have multiplied the same scaling factor among the outputs of said N CSD multipliers;

M inverse scalers (330, 331) for scaling the outputs of said M adders with M inverse-scaling factors which are the reciprocals of said M scaling factors; and

an adder (332) for adding the outputs of said M inverse scalers (330, 331) and producing a final filter output.

21. A CSD filter circuit as claimed in claim 20, wherein said CSD coefficient generator (310) groups real coefficients in predetermined digits according to characteristics of CSD coefficients, multiplies said grouped real coefficients by a predetermined gain, thus obtaining most approximate CSD code-converted coefficients, and calculates scaling factors for each group of real coefficients which minimize the sum of errors between said real coefficients and said CSD code-converted coefficients.

22. A CSD filter circuit as claimed in claim 20, wherein said CSD coefficient generator (310) calculates scaling factors for each real coefficient which minimizes the sum of errors between said real coefficients and CSD code-converted coefficients obtained by multiplying said real coefficients by a predetermined gain, groups said scaling factors according to the similarity of said scaling factors in their values, and produces a plurality of scaling factors.

23. A CSD filter circuit as claimed in claim 20, 21 or 22, wherein each of said N CSD multipliers (324-327) comprises:

shift matrices as many as the number L of non-zero digits in a CSD coefficient for shifting input data in accordance with each digit value of a CSD coefficient generated from said CSD coefficient generator;

L converters for converting the outputs of said L shift matrices into 2's complements according to said CSD coefficient; and

L-1 adders for adding the outputs of said L converters.

24. A CSD filter circuit as claimed in any of claims 20 to 23, wherein each of said M inverse scalers (330, 331) comprises a shifter for shifting the output of each of said M adders (328, 329) according to the value of each of a plurality of inverse-scaling factors, and outputting the shifted result.

25. A CSD filter circuit as claimed in any of claims 20 to 23, wherein each of said M inverse scalers (330, 331) comprises a CSD multiplier for multiplying the output of each of said M adders by each of a plurality of inverse-scaling factors.

26. A CSD filter circuit as claimed in any of claims 20 to 25, wherein said CSD coefficient generator (310) includes:

a microprocessor for obtaining real coefficients according to said filter characteristics, multiplying said real coefficients by a predetermined gain, thus obtaining most approximate CSD code-converted coefficients, and calculating scaling factors for each real coefficient which minimizes errors between said real coefficients and said CSD code-converted coefficients; and

a shifter for shifting said CSD code-converted coefficients and generating optimum CSD coefficients by using said scaling factors.

**Patentansprüche**

1. Verfahren zum Verarbeiten eines Signals in einem CSD-Filter mit erwünschten Filtereigenschaften, die durch Filterkoeffizienten erreicht werden, die in CSD-Codes ausgedrückt werden, wobei das Verfahren die folgenden Schritte umfasst:

   a) Ermitteln realer Koeffizienten, die auf die Filtereigenschaften optimiert sind;

   b) Generieren einer Vielzahl von Skalierungsfaktoren durch Berechnen von Skalierungsfaktoren für jeden realen Koeffizienten, der eine Abweichung zwischen den realen Koeffizienten und CSD-Code-konvertierten Koeffizienten, die ermittelt werden, indem die realen Koeffizienten mit einer vorgegebenen Verstärkung multipliziert werden, auf ein Minimum verringert;

   c) Erzeugen von CSD-Koeffizienten unter Verwendung der Vielzahl von Skalierungsfaktoren; und

   d) Verarbeiten von Eingangsdaten unter Verwendung der CSD-Koeffizienten.

2. Verfahren nach Anspruch 1, wobei die Abweichung in Schritt b) während der Umwandlung der realen Koeffizienten in CSD-Codes auf ein Minimum verringert wird und die in Schritt c) erzeugten CSD-Koeffizienten optimale CSD-Koeffizienten sind und die Verarbeitung in Schritt d) Filtern der Eingangsdaten umfasst.

3. Verfahren zum Verarbeiten eines Signals in einem CSD-Filter nach Anspruch 1 oder 2, wobei der Schritt c) die folgenden Schritte umfasst:

   c1) Umwandeln realer Koeffizienten in erste CSD-Koeffizienten durch Multiplizieren von Skalierungsfaktoren mit entsprechenden realen Koeffizienten; und
   c2) Verwenden eines Optimierungsatgorithmus, der auf dem Maß an Welligkeit in dem Frequenzbereich basiert, um optimierte zweite CSD-Koeffizienten aus den ersten CSD-Koeffizienten zu erzeugen.

4. Verfahren zum Verarbeiten eines Signals in einem CSD-Filter nach Anspruch 1, wobei:

   in dem Schritt b) die auf ein Minimum verringerte Abweichung eine Abweichung zwischen realen Koeffizienten und CSD-Codes ist, in die die realen Koeffizienten umgewandelt werden;

   in Schritt c) die CSD-Koeffizienten unter Verwendung der Skalierungsfaktoren für jeden der realen Koeffizienten erzeugt werden; und

   in dem Schritt d) Eingangsdaten mit dem CSD-Koeffzienten multipliziert werden;

   wobei das Verfahren den weiteren Schritt e) des Erzeugens eines End-Filterausgangs durch Skalieren des Ergebnisses der Multiplikation in dem Schritt d) mit Invers-Skalierungsfaktoren, die die Reziproken der Skalierungsfaktoren sind, umfasst.

5. Verfahren zum Verarbeiten eines Signals in einem CSD-Filter nach einem der vorangehenden Ansprüche, wobei in dem Schritt b) die Skalierungsfaktoren so berechnet werden, dass die quadrierte Summe der Abweichung zwischen den realen Koeffizienten und den CSD-Code-umgewandelten Koeffizienten, die ermittelt werden, indem die realen Koeffizienten mit einer vorgegebenen Verstärkung multipliziert werden, auf ein Minimum verringert wird.

6. Verfahren nach Anspruch 1, wobei:

   in dem Schritt b) die Skalierungsfaktoren erzeugt werden, indem Umwandlungsabweichungen zwischen den realen Koeffizienten und CSD-Codes, in die die realen Koeffizienten umgewandelt werden, auf ein Minimum verringert werden;

   in dem Schritt c) die CSD-Koeffizienten optimale CSD-Koeffizienten sind, die unter Verwendung der Vielzahl von Skalierungsfaktoren erzeugt werden; und

in dem Schritt d) das Filtern von Eingangsdaten unter Verwendung der CSD-Koeffizienten ausgeführt wird.

**7.** Verfahren nach einem der Ansprüche, 1, 2 oder 6, wobei in dem Schritt c) die CSD-Koeffizienten in dem Zeitbereich erzeugt werden, in dem die realen Koeffizienten mit der Vielzahl von Skalierungsfaktoren multipliziert werden.

**8.** Verfahren zum Verarbeiten eines Signals in einem CSD-Filter nach Anspruch 6 oder 7, wobei der Schritt c) die folgenden Schritte umfasst:

c1) Umwandeln der realen Koeffizienten in erste CSD-Koeffizienten durch Multiplizieren der realen Koeffizienten mit der Vielzahl von Skalierungsfaktoren; und

c2) Verwenden eines Optimierungsalgorithmus, der auf dem Maß an Welligkeit in dem Frequenzbereich beruht, um optimierte zweite CSD-Koeffizienten aus den ersten CSD-Koeffizienten zu erzeugen.

**9.** Verfahren nach Anspruch 1, wobei in dem Schritt b) die Skalierungsfaktoren so berechnet werden, dass Umwandlungsabweichungen zwischen den realen Koeffizienten und CSD-Codes, in die die realen Koeffizienten umgewandelt werden, auf ein Minimum verringert werden;

in dem Schritt c) die CSD-Koeffizienten erzeugt werden, indem die realen Koeffizienten unter Verwendung der Vielzahl von Skalierungsfaktoren in CSD-Codes umgewandelt werden; und

in dem Schritt d) Eingangsdaten mit den CSD-Koeffizienten multipliziert werden; das Verfahren einen weiteren Schritt e) des Erzeugens eines End-Filterausgangs durch Skalieren des Ergebnisses der Multiplikation des Schrittes d) mit einer Vielzahl Invers-Skalierungsfaktoren, die die Reziproken der Vielzahl von Skatierungsfaktoren sind, umfasst.

**10.** Verfahren zum Verarbeiten eines Signals in einem CSD-Filter nach Anspruch 6, 7, 8 oder 9, wobei der Schritt b) die folgenden Schritte umfasst:

b1) Gruppieren realer Koeffizienten vorgegebener Ziffern entsprechend Eigenschaften der CSD-Koeffizienten; und

b2) Berechnen von Skalierungsfaktoren für jede Gruppe, die die quadrierte Summe der Abweichung zwischen den gruppierten realen Koeffizienten und am nächsten liegenden CSD-Codes, die ermittelt werden, indem die gruppierten realen Koeffizienten mit einer vorgegebenen Verstärkung multipliziert werden, auf ein Minimum verringert.

**11.** Verfahren nach den Ansprüchen 6, 7, 8 oder 9, wobei der Schritt b) die folgenden Schritte umfasst:

b1') Berechnen von Skalierungsfaktoren für jeden realen Koeffizienten, der die quadrierte Summe der Abweichungen zwischen realen Koeffizienten und am nächsten liegenden CSD-Code-umgewandelten Koeffizienten, die ermittelt werden, indem jeder reale Koeffizient mit einer vorgegebenen Verstärkung multipliziert wird, auf ein Minimum verringert; und

b2') Gruppieren der in dem Schritt b1') für entsprechende reale Koeffizienten berechneten Skalierungsfaktoren entsprechend der Ähnlichkeit der Skalierungsfaktoren hinsichtlich ihrer Werte.

**12.** N-Anzapfungs-CSD-Filterschaltung, die durch Filterkoeffizienten, die in CSD-Codes ausgedrückt werden, gewünschte Filtereigenschaften hat und die umfasst:

N-1-Grund-Verzögerungsglieder (221-223), die in Reihe verbunden sind, um Eingangsdaten zu verzögern:

eine Einrichtung zum Generieren eines CSD-Koeffizienten (210), die eine Vielzahl von Skalierungsfaktoren für jeden realen Koeffizienten berechnet, der eine Abweichung zwischen den realen Koeffizienten und CSD-Code-umgewandelten Koeffizienten, die ermittelt werden, indem die entsprechend den Filtereigenschaften ermittelten realen Koeffizienten mit einer vorgegebenen Verstärkung multipliziert werden, auf

**16**

ein Minimum verringert und die unter Verwendung der berechneten Skalierungsfaktoren optimale CSD-Koeffizienten generiert;

N CSD-Multiplizierglieder (224-227), die die Ausgänge der N-1-Grundverzögerungsglieder (221-223) mit den CSD-Koeffizienten multiplizieren;

N Invers-Skalierglieder (228-231), die die Ausgänge der N CSD-Multiplizierer (224-227) mit Invers-Skalierungsfaktoren skalieren, die die Reziproken der für die realen Koeffizienten berechneten Skatierungsfaktoren sind; und

ein Addierglied (232), das die Ausgänge der N inversen Skalierer addiert und einen End-Filterausgang erzeugt.

13. CSD-Filterschaltung nach Anspruch 12, wobei jedes der CSD-Multiplizierglieder (224-227) umfasst:

Shift-Matrizen (224.1, 224.2), deren Anzahl der Anzahl L von Nicht-Null-Ziffern in einem CSD-Koeffizienten entspricht, und die die Eingangsdaten entsprechend jedem Ziffernwert eines CSD-Koeffzienten verschieben, der in der Einrichtung zum Generieren von CSD-Koeffizienten (210) generiert wird;

L Wandler (224.3, 224.4), der die Ausgänge der L Shift-Matrizen (224.1. 224.2) in Zweierkomplemente umwandelt; und

L 1-Addierglieder (224.5), die die Ausgänge von L Wandlern addieren.

14. CSD-Filterschaltung nach Anspruch 13, wobei das CSD-Filter von einem adaptiven Typ ist und die Shift-Matrix (224.1, 224.2) ein Ausgangsschieberegister umfasst.

15. CSD-Filterschaltung nach Anspruch 13, wobei das CSD-Filter von einem festen Typ ist und die Shift-Matrix (224.1, 224.2) ein Schieberegister umfasst.

16. CSD-Filterschaltung nach Anspruch 13, 14 oder 15, wobei jeder der L Wandler (224.3, 224.4) einen Inverter und ein Addierglied umfasst, um den Ausgang einer entsprechenden Shift-Matrix nur in einer Ziffer des CSD-Koeffizienten mit "-1" in Zweierkomplemente umzuwandeln.

17. CSD-Filtereinheit nach einem der Ansprüche 12 bis 16, wobei jeder der N Invers-Skalierer (228-231) Schieberegister zum Verschieben des Ausgangs jedes CSD-Multipliziergliedes (224-227) gemäß dem Wert jedes Invers-Skalierungsfaktors und zum Ausgeben des verschobenen Ergebnisses umfasst.

18. CSD-Filterschaltung nach einem der Ansprüche 12 bis 16, wobei jeder von N Invers-Skalierern (228-231) ein CSD-Multiplizierglied zum Multiplizieren des Ausgangs jedes CSD-Multiplizierers mit jedem Invers-Skalierungsfaktor umfasst.

19. CSD-Filterschaltung nach einem der Ansprüche 12 bis 16, wobei die Einrichtung (210) zum Generieren eines CSD-Koeffizienten enthält:

einen Mikroprozessor, der gemäß den Filtereigenschaften reale Koeffizienten ermittelt und Skalierungsfaktoren für jeden der realen Koeffizienten berechnet, der Abweichungen zwischen den realen Koeffizienten und am nächsten liegenden CSD-Code-umgewandelten Koeffizienten, die ermittelt werden, indem die realen Koeffizienten mit einer vorgegebenen Verstärkung multipliziert werden, auf ein Minimum verringert; und

ein Schieberegister, das die CSD-Code-umgewandelten Koeffizienten verschiebt und unter Verwendung der Skalierungsfaktoren optimale CSD-Koeffizienten generiert.

20. N-Anzapfungs-CSD-Filterschaltung, die durch Filterkoeffizienten, die in CSD-Codes ausgedrückt werden, gewünschte Filtereigenschaften hat und die umfasst:

N-1 Grundverzögerungsglieder (321-323), die in Reihe verbunden sind, um Eingangsdaten zu verzögern;

eine Einrichtung (310) zum Generieren eines CSD-Koeffizienten, die CSD-Koeffizienten unter Verwendung einer Vielzahl von Skalierungsfaktoren generiert, die Abweichungen zwischen den realen Koeffizienten und am nächsten liegenden CSD-Code-umgewandelten Koeffizienten, die ermittelt werden, indem die realen Koeffizienten mit einer vorgegebenen Verstärkung multipliziert werden, auf ein Minimum verringern;

N CSD-Multiplizierglieder (324-327), die Ausgänge der N-1 Einzel-Verzögerungsglieder mit CSD-Koeffizienten multiplizieren, die durch M Skalierungsfaktoren generiert werden;

M Addierglieder (328-329), die von den Ausgängen der N CSD-Multiplizierglieder die Ausgänge von CSD-Multipliziergliedern (324-327) addieren, die mit dem gleichen Skalierungsfaktor multipliziert worden sind;

M Invers-Skalierglieder (330, 331), die die Ausgänge der M Addierglieder mit M Invers-Skalierungsfaktoren skalieren, die die Reziproken der M Skalierungsfaktoren sind; und

ein Addierglied (332), das die Ausgänge der M Invers-Skalierglieder (330, 331) addiert und einen End-Filterausgang erzeugt.

21. CSD-Filterschaltung nach Anspruch 20, wobei die Einrichtung (310) zum Generieren von CSD-Koeffzienten reale Koeffizienten Eigenschaften von CSD-Koeffizienten in vorgegebenen Ziffern gemäß gruppiert, die gruppierten realen Koeffizienten mit einer vorgegebenen Verstärkung multipliziert und so am nächsten liegende CSD-Code-umgewandelte Koeffizienten ermittelt und Skatierungsfaktoren für jede Gruppe realer Koeffizienten berechnet, die die Summe von Abweichungen zwischen den realen Koeffizienten und den CSD-Code-umgewandelten Koeffizienten auf ein Minimum verringern.

22. CSD-Filterschaltung nach Anspruch 20, wobei die Einrichtung (310) zum Generieren von CSD-Koeffizienten Skalierungsfaktoren für jeden realen Koeffizienten berechnet, der die Summe von Abweichungen zwischen den realen Koeffizienten und CSD-Code-umgewandelten Koeffizienten, die ermittelt werden, indem die realen Koeffizienten mit einer vorgegebenen Verstärkung multipliziert werden, auf ein Minimum verringert, die Skalierungsfaktoren entsprechend der Ähnlichkeit der Skalierungsfaktoren hinsichtlich ihrer Werte gruppiert und eine Vielzahl von Skalierungsfaktoren erzeugt.

23. CSD-Filterschaltung nach Anspruch 20, 21 oder 22, wobei jedes der N CSD-Multiplizierglieder (324-327) umfasst:

Shift-Matrizen, deren Anzahl der Anzahl L von Nicht-Null-Ziffern in einem CSD-Koeffizienten entspricht, und die Eingangsdaten entsprechend jedem Ziffernwert eines CSD-Koeffizienten verschieben, der von der Einrichtung zum Generieren von CSD-Koeffizienten generiert wird;

L Wandler, die die Ausgänge der L Shift-Matrizen gemäß dem CSD-Koeffizienten in Zweierkomplemente umwandeln: und

L-1 Addierglieder, die die Ausgänge der L Wandler addieren.

24. CSD-Filterschaltung nach einem der Ansprüche 20 bis 23, wobei jedes der M Invers-Skalierglieder (330, 331) ein Schieberegister umfasst, das den Ausgang jedes der M Addierglieder (328. 329) entsprechend dem Wert jedes einer Vielzahl von Invers-Skalierungsfaktoren verschiebt und das verschobene Ergebnis ausgibt.

25. CSD-Filterschaltung nach einem der Ansprüche 20 bis 23, wobei jedes der M Invers-Skalierglieder (330, 331) ein CSD-Muttiplizierglied umfasst, das den Ausgang jedes der M Addierglieder mit jedem einer Vielzahl von Invers-Skalierungsfaktoren multipliziert.

26. CSD-Filterschaltung nach einem der Ansprüche 20 bis 25, wobei die Einrichtung (310) zum Generieren von CSD-Koeffizienten enthält:

einen Mikroprozessor, der gemäß den Filtereigenschaften reale Koeffizienten ermittelt, die realen Koeffizienten mit einer vorgegebenen Verstärkung multipliziert und so am nächsten liegenden CSD-Code-umgewandelte Koeffizienten ermittelt und Skalierungsfaktoren für jeden realen Koeffizienten berechnet, der Abweichungen zwischen den realen Koeffizienten und den CSD-Code-umgewandelten Koeffizienten auf ein Minimum verringert; und

ein Schieberegister, das die CSD-Code-umgewandelten Koeffizienten verschiebt und unter Verwendung der Skalierungsfäktoren optimale CSD-Koeffizienten generiert.

**Revendications**

1. Procédé pour traiter un signal dans un filtre CSD ayant des caractéristiques de filtre voulues obtenues par des coefficients de filtre exprimées en codes CSD, le procédé comportant les étapes consistant à :

    (a) obtenir des coefficients réels optimisés pour lesdites caractéristiques de filtre,
    (b) générer une pluralité de facteurs d'échelle en calculant des facteurs d'échelle pour chaque coefficient réel, ce qui minimise une erreur entre lesdits coefficients réels et les coefficients convertis en codes CSD obtenus en multipliant lesdits coefficients réels par un gain prédéterminé,
    (c) produire des coefficients CSD en utilisant ladite pluralité de facteurs d'échelle, et
    (d) traiter des données d'entrée en utilisant lesdits coefficients CSD.

2. Procédé selon la revendication 1, dans lequel ladite erreur de l'étape (b) est minimisée pendant la conversion des coefficients réels en codes CSD, dans lequel lesdits coefficients CSD produits à l'étape (c) sont des coefficients CSD optimum et dans lequel ledit traitement de l'étape (d) comporte le filtrage des données d'entrée.

3. Procédé pour traiter un signal dans un filtre CSD selon la revendication 1 ou 2, dans lequel ladite étape (c) comporte les étapes consistant à :

    (c1) convertir des coefficients réels en premiers coefficients CSD en multipliant des facteurs d'échelle par des coefficients réels respectifs, et
    (c2) utiliser un algorithme d'optimisation basé sur la quantité d'ondulation dans le domaine fréquentiel pour produire des seconds coefficients CSD optimisés à partir desdits premiers coefficients CSD.

4. Procédé pour traiter un signal dans un filtre CSD selon la revendication 1, dans lequel :

    à ladite étape (b) l'erreur minimisée est une erreur entre lesdits coefficients réels et les codes CSD en lesquels lesdits coefficients réels sont convertis,
    à l'étape (c), les coefficients CSD sont produits en utilisant lesdits facteurs d'échelle pour chacun desdits coefficients réels,
    et à ladite étape (d), des données d'entrée sont multipliées par lesdits coefficients CSD,
    le procédé comportant l'étape supplémentaire (e) consistant à produire une sortie de filtre finale en mettant à l'échelle le résultat de la multiplication à ladite étape (d) par des facteurs d'échelle inverse qui sont les réciproques desdits facteurs d'échelle.

5. Procédé pour traiter un signal dans un filtre CSD, selon l'une quelconque des revendications précédentes, dans lequel à ladite étape (b), lesdits facteurs d'échelle sont calculés de manière à minimiser la somme d'erreur quadratique entre lesdits coefficients réels et lesdits coefficients convertis en codes CSD obtenus en multipliant lesdits coefficients réels par un gain prédéterminé.

6. Procédé selon la revendication 1, dans lequel :

    à ladite étape (b) les facteurs d'échelle sont produits pour minimiser des erreurs de conversion entre lesdits coefficients réels et les codes CSD en lesquels lesdits coefficients réels sont convertis,
    à ladite étape (c) les coefficients CSD sont des coefficients CSD optimum produits en utilisant ladite pluralité de facteurs d'échelle, et
    à ladite étape (d) un filtrage des données d'entrée est exécuté en utilisant lesdits coefficients CSD.

7. Procédé selon l'une quelconque des revendications 1, 2 ou 6, dans lequel à ladite étape (c), lesdits coefficients CSD sont produits dans le domaine temporel en multipliant lesdits coefficients réels par ladite pluralité de facteurs d'échelle.

8. Procédé pour traiter un signal dans un filtre CSD selon la revendication 6 ou 7, dans lequel ladite étape (c) comporte les étapes consistant à :

(c1) convertir lesdits coefficients réels en premiers coefficients CSD en multipliant lesdits coefficients réels par ladite pluralité de facteurs d'échelle, et

(c2) utiliser un algorithme d'optimisation basé sur la quantité d'ondulation dans le domaine fréquentiel pour produire des seconds coefficients CSD optimisés à partir desdits premiers coefficients CSD.

9. Procédé selon la revendication 1, dans lequel à ladite étape (b), les facteurs d'échelle sont calculés pour minimiser des erreurs de conversion entre lesdits coefficients réels et les codes CSD en lesquels lesdits coefficients réels sont convertis,

à ladite étape (c), les coefficients CSD sont produits en convertissant lesdits coefficients réels en codes CSD en utilisant ladite pluralité de facteurs d'échelle, et

à ladite étape (d), des données d'entrée sont multipliées par lesdits coefficients CSD,

le procédé comportant une étape supplémentaire (e) consistant à produire une sortie de filtre finale en mettant à l'échelle le résultat de la multiplication de ladite étape (d) à l'aide d'une pluralité de facteurs d'échelle inverse qui sont les réciproques de ladite pluralité de facteurs d'échelle.

10. Procédé pour traiter un signal dans un filtre CSD selon la revendication 6, 7, 8 ou 9, dans lequel ladite étape (b) comporte les étapes consistant à :

(b1) regrouper des coefficients réels de chiffres prédéterminés conformément aux caractéristiques de coefficients CSD, et

(b2) calculer des facteurs d'échelle pour chaque groupe qui minimise la somme d'erreur quadratique entre lesdits coefficients réels regroupés et les codes CSD les plus approchants obtenus en multipliant lesdits coefficients réels regroupés par un gain prédéterminé.

11. Procédé selon la revendication 6, 7, 8 ou 9, dans lequel ladite étape (b) comporte les étapes consistant à :

(b1') calculer des facteurs d'échelle pour chaque coefficient réel qui minimise la somme d'erreur quadratique entre lesdits coefficients réels et les coefficients convertis en code CSD les plus approchants obtenus en multipliant chaque coefficient réel par un gain prédéterminé, et

(b2') regrouper lesdits facteurs d'échelle calculés à ladite étape (b1') pour des coefficients réels respectifs conformément à la similitude desdits facteurs d'échelle en ce qui concerne leurs valeurs.

12. Circuit de filtrage CSD à N prises ayant des caractéristiques de filtre voulues par l'intermédiaire de coefficients de filtre exprimés en codes CSD, comportant :

N-1 unités à retard (221-223) montées en série pour retarder des données d'entrée,

un générateur de coefficients CSD (210) pour générer une pluralité de facteurs d'échelle en calculant des facteurs d'échelle pour chaque coefficient réel qui minimise une erreur entre lesdits coefficients réels et des coefficients convertis en codes CSD obtenus en multipliant lesdits coefficients réels obtenus conformément auxdites caractéristiques de filtre par un gain prédéterminé, et pour générer des coefficients CSD optimum en utilisant lesdits facteurs d'échelle calculés,

N multiplicateurs CSD (224-227) pour multiplier des sorties des N-1 unités à retard (221-223) par lesdits coefficients CSD,

N dispositifs de mise à l'échelle inverse (228-231) pour mettre à l'échelle les sorties desdits N multiplicateurs CSD (224-227) à l'aide de facteurs d'échelle inverse qui sont les réciproques desdits facteurs d'échelle calculés pour lesdits coefficients réels, et

un additionneur (232) pour additionner les sorties desdits N dispositifs de mise à l'échelle inverse et produire une sortie de filtre finale.

13. Circuit de filtrage CSD selon la revendication 12, dans lequel chacun desdits multiplicateurs CSD (224-227) comporte :

des matrices à décalage (224.1, 224.2) aussi nombreuses que le nombre L de chiffres non-nuls dans un coefficient CSD pour décaler lesdites données d'entrée conformément à chaque valeur de chiffre d'un coefficient CSD généré dans ledit générateur de coefficients CSD 210,

L convertisseurs (224.3, 224.4) pour convertir les sorties desdites L matrices à décalage (224.1, 224.2) en compléments 2, et

L-1 additionneurs (224.5) pour ajouter les sorties des L convertisseurs.

**14.** Circuit de filtrage CSD selon la revendication 13, dans lequel ledit filtre CSD est un type adaptatif, et ladite matrice à décalage (224.1, 224.2) comporte un dispositif à décalage à effet de tonneau.

**15.** Circuit de filtrage CSD selon la revendication 13, dans lequel ledit filtre CSD est un type fixe et ladite matrice à décalage (224.1, 224.2) comporte un dispositif à décalage.

**16.** Circuit de filtrage CSD selon la revendication 13, 14 ou 15, dans lequel chacun desdits L convertisseurs (224.3, 224.4) comporte un inverseur et un additionneur pour convertir la sortie d'une matrice à décalage correspondante en compléments 2 uniquement dans un chiffre ayant "-1" dudit coefficient CSD.

**17.** Circuit de filtrage CSD selon l'une quelconque des revendications 12 à 16, dans lequel chacun desdits N dispositifs de mise à l'échelle inverse (228-231) comporte des dispositifs à décalage pour décaler la sortie de chaque multiplicateur CSD (224-227) conformément à la valeur de chaque facteur d'échelle inverse, et délivrer en sortie le résultat décalé.

**18.** Circuit de filtrage CSD selon l'une quelconque des revendications 12 à 16, dans lequel chacun des N dispositifs de mise à l'échelle inverse (228-231) comporte un multiplicateur CSD pour multiplier la sortie de chaque multiplicateur CSD par chaque facteur d'échelle inverse.

**19.** Circuit de filtrage CSD selon l'une quelconque des revendications 12 à 16, dans lequel ledit générateur de coefficients CSD (210) inclut :

un microprocesseur pour obtenir un coefficient réel conformément auxdites caractéristiques de filtre, et calculer des facteurs d'échelle pour chacun desdits coefficients réels qui minimise des erreurs entre lesdits coefficients réels et les coefficients convertis en codes CSD les plus approchants obtenus en multipliant lesdits coefficients réels par un gain prédéterminé, et
un dispositif à décalage pour décaler lesdits coefficients convertis en codes CSD et générer des coefficients CSD optimum en utilisant lesdits facteurs d'échelle.

**20.** Circuit de filtrage CSD à N prises ayant des caractéristiques de filtre voulues par l'intermédiaire de coefficients de filtre exprimés en codes CSD, comportant :

N-1 unités à retard (321-323) montées en série pour retarder des données d'entrée,
un générateur de coefficients CSD (310) pour générer des coefficients CSD en utilisant une pluralité de facteurs d'échelle qui minimisent des erreurs entre lesdits coefficients réels et des coefficients convertis en codes CSD les plus approchants obtenus en multipliant lesdits coefficients réels par un gain prédéterminé,
N multiplicateurs CSD (324-327) pour multiplier des sorties desdites N-1 unités à retard par des coefficients CSD générés via lesdits M facteurs d'échelle,
M additionneurs (328-329) pour additionner les sorties des multiplicateurs CSD (324-327) qui ont multiplié le même facteur d'échelle parmi les sorties desdits N multiplicateurs CSD,
M dispositifs de mise à l'échelle inverse (330-331) pour mettre à l'échelle les sorties desdits M additionneurs à l'aide de M facteurs d'échelle inverse qui sont les réciproques desdits M facteurs d'échelle, et
un additionneur (332) pour additionner les sorties desdits M dispositifs de mise à l'échelle inverse (330, 331) et produire une sortie de filtre finale.

**21.** Circuit de filtrage CSD selon la revendication 20, dans lequel ledit générateur de coefficients CSD (310) regroupe des coefficients réels de chiffres prédéterminés conformément à des caractéristiques de coefficients CSD, multiplie lesdits coefficients réels regroupés par un gain prédéterminé, obtenant ainsi des coefficients convertis en codes CSD les plus approchants, et calcule des facteurs d'échelle pour chaque groupe de coefficients réels qui minimisent la somme d'erreurs entre lesdits coefficients réels et lesdits coefficients convertis en codes CSD.

**22.** Circuit de filtrage CSD selon la revendication 20, dans lequel ledit générateur de coefficients CSD (310) calcule des facteurs d'échelle pour chaque coefficient réel qui minimise la somme d'erreurs entre lesdits coefficients réels et les coefficients convertis en codes CSD obtenus en multipliant lesdits coefficients réels par un gain prédéterminé, regroupe lesdits facteurs d'échelle conformément à la similitude desdits facteurs d'échelle en ce qui concerne leurs valeurs, et produit une pluralité de facteurs d'échelle.

**23.** Circuit de filtrage CSD selon la revendication 20, 21 ou 22, dans lequel chacun desdits N multiplicateurs CSD (324-327) comporte :

des matrices à décalage aussi nombreuses que le nombre L de chiffres non-nuls dans un coefficient CSD pour décaler des données d'entrée conformément à chaque valeur de chiffre d'un coefficient CSD généré dans ledit générateur de coefficients CSD,
L convertisseurs pour convertir les sorties desdites L matrices à décalage en compléments 2 conformément audit coefficient CSD, et
L-1 additionneurs pour additionner les sorties desdits L convertisseurs.

**24.** Circuit de filtrage CSD selon l'une quelconque des revendications 20 à 23, dans lequel chacun desdits L dispositifs de mise à l'échelle inverse (330, 331) comporte un dispositif à décalage pour décaler la sortie de chacun desdits M additionneurs (328, 329) conformément à la valeur de chaque facteur parmi une pluralité de facteurs d'échelle inverse, et délivrer en sortie le résultat déphasé.

**25.** Circuit de filtrage CSD selon l'une quelconque des revendications 20 à 23, dans lequel chacun desdits M dispositifs de mise à l'échelle inverse (330, 331) comporte un multiplicateur CSD pour multiplier la sortie de chacun desdits M additionneurs par chaque facteur parmi une pluralité de facteurs d'échelle inverse.

**26.** Circuit de filtrage CSD selon l'une quelconque des revendications 20 à 25, dans lequel ledit générateur de coefficients CSD (310) inclut :

un microprocesseur pour obtenir des coefficients réels conformément auxdites caractéristiques de filtre, multiplier lesdits coefficients réels par un gain prédéterminé, obtenant ainsi des coefficients convertis en codes CSD les plus approchants, et calculer des facteurs d'échelle pour chaque coefficient réel qui minimise des erreurs entre lesdits coefficients réels et lesdits coefficients convertis en codes CSD, et
un dispositif à décalage pour décaler lesdits coefficients convertis en codes CSD et générer des coefficients CSD optimum en utilisant lesdits facteurs d'échelle.

# FIG. 1

- • "6-DIGIT"
- ✦ "6-DIGIT"
- ▣ "8-DIGIT"
- ✕ "8-DIGIT"

8-DIGIT CODE (L=3)

8-DIGIT CODE (L=2)

6-DIGIT CODE (L=3)

6-DIGIT CODE (L=2)

0     0.2     0.4     0.6     0.8     1

CSD COEFFICIENT VALUES

# FIG. 6

# FIG. 2 (PRIOR ART)

EP 0 766 388 B1

# FIG. 3 (PRIOR ART)

HERE ⊗ :CSD MULTIPLIER

EP 0 766 388 B1

# FIG. 4

Real filter coefficients block (210): coef_0, coef_1, coef_2, coef_3, ..., coef_(N-1) → REAL FILTER COEFFICIENTS

SF block: SF_0, SF_1, SF_2, SF_3, ..., SF_(N-1)

CSD filter coefficients block: CSD coef_0, CSD coef_1, CSD coef_2, CSD coef_3, ..., CSD coef_(N-1) → CSD FILTER COEFFICIENTS

DATA INPUT → N-TAP FILTER (220)

RSF block: RSF_0, RSF_1, RSF_2, RSF_3, ..., RSF_(N-1) → CSD FILTER → FILTER OUTPUT

EP 0 766 388 B1

# FIG. 5

EP 0 766 388 B1

# FIG. 7

# FIG. 8

DATA INPUT

321  322  323

310  310

coef_0 → SF_0
coef_1 → SF_0

324  325

328

RSF_0  330

coef_2 → SF_1
coef_3 → SF_1

326  327

329  331

RSF_1

332

FILTER OUTPUT

EP 0 766 388 B1

29